# EUROPEAN PATENT SPECIFICATION

(11) **EP 4 391 385 B1**
(45) Date of publication and mention of the grant of the patent: **07.10.2026**
(21) Application number: 22216129.1
(22) Date of filing: 22.12.2022
(51) Int. Cl.: H03L 7/099, G06F 1/03

(54) **DIRECT DIGITAL SYNTHESIZER MODULE, MEASUREMENT SYSTEM, AND METHOD OF OPERATING A DIRECT DIGITAL SYNTHESIZER MODULE**
DIREKTES DIGITALES SYNTHESIZERMODUL, MESSSYSTEM UND VERFAHREN ZUM BETRIEB EINES DIREKTEN DIGITALEN SYNTHESIZERMODULS
MODULE SYNTHÉTISEUR NUMÉRIQUE DIRECT, SYSTÈME DE MESURE ET PROCÉDÉ DE FONCTIONNEMENT D'UN MODULE SYNTHÉTISEUR NUMÉRIQUE DIRECT

(43) Date of publication of application: 26.06.2024
(73) Proprietor: Rohde & Schwarz GmbH & Co. KG, 81671 München (DE)
(72) Inventor: Seeger, Julius, 81671 Munich (DE)
(74) Representative: Novagraaf Group

(56) References cited:
- GB-A- 2 352 346
- US-A1- 2016 164 531
- US-B1- 9 244 885
- BOZIC M ET AL: "Elimination of non-harmonic spurious in direct digital synthesis", 19930101, 1 January 1993 (1993-01-01), pages 6/1 - 6/8, XP006520835

## Description

The invention generally relates to a direct digital synthesizer module. The invention further relates to a measurement system and to a method of operating a direct digital synthesizer module.

Direct digital synthesizers are, referred to the CLK of the phase accumulator, highly phase stable. Modern direct digital synthesizers enable the user to set the frequency and initial phase via dedicated registers, namely via an FTW (frequency tuning word) and an initial phase.

Certain measurement setups require two or more direct digital synthesizers having a predefined phase relation to each other. In the state of the art, this phase relation is usually achieved by setting the respective initial phase values of the direct digital synthesizers, wherein the initial phase values of all direct digital synthesizers have to be set simultaneously within a single clock cycle.

Thus, setting the initial phase values of the direct digital synthesizers has to be timed in a very precise manner in order to set a desire phase relation between the direct digital synthesizers.

US 2016/164531 A1 discloses a measurement system according to the preamble of claim 1.

US 9 244 885 B1 discloses a direct digital synthesizer with two subtraction-bypass stages, an accumulation stage, and a consolidation stage, which are for a redundant number system. The direct digital synthesizer comprises a phase accumulator module that is configured to adapt a fed-back phase value.

GB 2 352 346 A discloses a direct digital synthesis circuit that is configured to generate a variable frequency cyclic waveform. The direct digital synthesis circuit has a phase accumulator module with a frequency control input for a phase increment value.

BOZIC M ET AL: "Elimination of non-harmonic spurious in direct digital synthesis", 19930101, 1 January 1993 (1993-01-01), pages 6/1-6/8, XP006520835 discloses a direct digital synthesizer with a phase accumulator that is configured to adapt a phase value fed back to an adder unit.

The object of the present invention is to provide a direct signal synthesizer module that allows for a less time-critical setting of the phase relation.

According to the present invention, the problem is solved by a measurement system comprising at least one direct digital synthesizer (DDS) module according to claim 1.Therein and in the following, the term "module" is understood to describe suitable hardware, suitable software, or a combination of hardware and software that is configured to have a certain functionality.

The hardware may, inter alia, comprise a CPU, a GPU, an FPGA, an ASIC, or other types of electronic circuitry.

According to the present invention, the phase signal fed back to the phase increment sub-module is adapted based on the PSW in order to obtain a desired phase signal that is output by the phase accumulator module.

In other words, the phase of an output signal of the DDS module is adapted by adapting the phase signal fed back to the phase increment sub-module based on the PSW.

Thus, a desired phase relation between an output signal of the DDS module and another signal, e.g. another output signal of another DDS module, can be obtained by providing the PSW to the DDS module.

In fact, the phase signal fed back to the phase increment sub-module can be adapted in an arbitrary clock cycle of the phase accumulator module.

Thus, instead of initializing multiple DDS modules simultaneously, a phase correction is applied to the phase signal fed back to the phase increment sub-module, which is not time-critical and does not require a precise coordination of multiple different DDS modules.

The DDS module may comprise a converter module downstream of the phase accumulator module, wherein the converter module is configured to convert the phase signal output by the phase accumulator module into an amplitude signal. In general, the converter module is configured to map the phase of the phase signal to a corresponding amplitude of the amplitude signal, such that signals having arbitrary shape can be generated, e.g. sine-shaped amplitude signals, sawtooth-shaped amplitude signals, etc.

The DDS module may comprises a digital-to-analog converter (DAC) downstream of the phase accumulator module, particularly downstream of the converter module. The DAC is configured to convert a digital output signal of the DDS module, particularly the amplitude signal, into an analog output signal of the DDS module.

The DDS module may be integrated on a chip. For example, the chip may be a dedicated DDS chip. However, it is to be understood that the DDS module may also be integrated on a chip together with other electronic components.

The at least one further DDS module may be configured like the DDS module described above, but this is not necessary.

In fact, in order to set a particular phase relation of analog outputs signals of two DDS modules, only a single PSW has to be determined for one of the two DDS modules.

If a total number of N DDS modules is provided, and phase relations between the N DDS modules are to be set, (N-1) PSWs have to be determined by means of the analysis module.

In fact, the phases of the analog output signals of (N-1) DDS modules may be adapted relative to the phase of the analog output signal of the remaining DDS module based on the (N-1) determined PSWs.

According to an aspect of the present invention, the phase correction sub-module is configured to receive a phase shift trigger signal, wherein the phase correction sub-module is configured to adapt the phase signal fed back to the phase increment sub-module upon receiving the phase shift trigger signal. In other words, the timing of adapting the phase signal fed back to the phase increment sub-module can be controlled by providing the phase shift trigger signal to the phase correction sub-module.

In an embodiment of the present invention, the phase correction sub-module is configured to replace the phase signal fed back to the phase increment sub-module with a corrected phase signal. Particularly, the phase correction sub-module comprises a multiplexer sub-module, wherein the multiplexer sub-module is configured to selectively forward the phase signal or the corrected phase signal to the phase increment sub-module. In other words, instead of feeding back an actual phase signal output by the phase increment sub-module, the corrected phase signal is fed back or rather forwarded to the phase increment sub-module. This way, an arbitrary phase signal can be set.

Therein, the corrected phase signal may correspond to the desired phase signal that should be output by the phase accumulator module in the current clock cycle.

During normal operation, the multiplexer sub-module may be configured or rather controlled to feed back the phase signal output by the phase increment sub-module to the phase increment sub-module.

In order to adapt the phase of the (analog) output signal of the DDS module, the multiplexer sub-module is controlled to forward the corrected phase signal to the phase increment sub-module instead of the actual phase signal output by the phase increment sub-module for a predetermined time interval, e.g. for one clock cycle.

For example, the multiplexer sub-module may be controlled by means of the phase shift trigger signal described above, such that the multiplexer sub-module forwards the corrected phase signal to the phase increment sub-module upon receiving the phase shift trigger signal.

According to another aspect of the present invention, the phase correction sub-module is configured to replace the phase signal fed back to the phase increment sub-module with a corrected phase signal during a single clock cycle of the clock signal. Accordingly, during a certain clock cycle, the phase correction sub-module receives the corrected phase signal instead of the phase signal output by the phase correction sub-module. During the next clock cycle, the phase correction sub-module receives the phase signal output by the phase correction sub-module via the feedback path, which corresponds to the corrected phase signal incremented by the predetermined phase increment. Thus, the correction or rather adaptation of the phase of the output signal of the DDS module can be performed within a single clock cycle.

A further aspect of the present invention provides that the phase correction sub-module is configured to add a phase correction signal to the phase signal fed back to the phase increment sub-module. Particularly, the phase correction sub-module comprises an adder sub-module, wherein the adder sub-module is configured to add the phase correction signal to the phase signal fed back to the phase increment sub-module. In other words, the phase signal output by the phase increment sub-module is corrected by adding the phase correction signal, such that a desired phase signal is obtained.

Accordingly, the phase correction signal may correspond to the difference between the desired phase signal and the actual phase signal output by the phase accumulator module in the current clock cycle.

The phase correction sub-module may comprise a multiplexer sub-module, wherein the multiplexer sub-module is configured to selectively forward the phase correction signal to the adder sub-module. More precisely, the multiplexer sub-module is configured to selectively forward the phase correction signal or a zero-signal to the adder sub-module, wherein the zero-signal does not alter the phase signal when added to the phase signal.

During normal operation, the multiplexer sub-module may be configured or rather controlled to forward the zero-signal to the adder sub-module or to forward no signal at all.

In order to adapt the phase of the (analog) output signal of the DDS module, the multiplexer sub-module is controlled to forward the phase correction signal to the adder sub-module for a predetermined time interval, e.g. for one clock cycle.

For example, the multiplexer sub-module may be controlled by means of the phase shift trigger signal described above, such that the multiplexer sub-module forwards the phase correction signal to the adder sub-module upon receiving the phase shift trigger signal.

Particularly, the phase correction sub-module is configured to add the phase correction signal to the phase signal fed back to the phase increment sub-module during a single clock cycle of the clock signal. Thus, the correction or rather adaptation of the phase of the output signal of the DDS module can be performed within a single clock cycle.

The measurement system may comprise a measurement instrument, wherein the at least one DDS module is integrated into the measurement instrument. For example, the measurement instrument may be an oscilloscope, particularly a digital oscilloscope, a vector network analyzer, a spectrum analyzer, a standalone signal generator, etc.

The analysis module may further be configured to forward the determined PSW to the at least one DDS module, or more precisely to the phase shift register of the at least one DDS module.

The analysis module may be integrated into the measurement instrument described above.

However, it is also conceivable that the analysis module is integrated into another electronic device.

Particularly, the analysis module is configured to repeatedly determine the PSW in predefined time intervals. In other words, the phase relation between the analog output signal of the at least one DDS module and the phase reference signal may be monitored continuously, and the phase of the analog output signal of the at least one DDS module may be corrected by providing an appropriate PSW to the at least one DDS module if necessary.

Alternatively or additionally, the analysis module may be configured to determine the PSW after the FTW of the at least one DDS module has been updated. Thus, it is ensured that a desired phase relation between the analog output signal of the at least one DDS module and the phase reference signal is obtained after the FTW has been updated.

In an embodiment of the present invention, the measurement system comprises a directional coupler, wherein the directional coupler is configured to forward the analog output signal of the at least one DDS module to the analysis module. The directional coupler may further be configured to forward the analog output signal of the at least one DDS module to a measurement port, to another electronic component, or to another signal path.

Particularly, the directional coupler is established as a 3-port coupler.

The measurement system may comprise at least one further directional coupler, wherein the at least one further directional coupler is configured to forward the phase reference signal the analysis module. The at least one further directional coupler may further be configured to forward the phase reference signal to a measurement port, to another electronic component, or to another signal path.

Particularly, the at least one further directional coupler is established as a 3-port coupler.

The measurement system may comprise at least one further DDS module, wherein the measurement system comprises a common clock source for the at least one DDS module and for the at least one further DDS module.

However, it is also conceivable that different clock sources are provided for the at least one DDS module and for the at least one further DDS module.

According to the invention, the problem further is solved by a method of operating a direct digital synthesizer (DDS) module according to claim 12.

Regarding the further advantages and properties of the method, reference is made to the explanations given above with respect to the DDS module and the measurement system, which also hold for the method and vice versa.

The foregoing aspects and many of the attendant advantages of the claimed subject matter will become more readily appreciated as the same become better understood by reference to the following detailed description, when taken in conjunction with the accompanying drawings, wherein:
- Figure 1 schematically shows a measurement system according to the present invention;
- Figure 2 schematically shows a signal generator module of the measurement system of Figure 1 in more detail;
- Figure 3 schematically shows a DDS module according to the present invention;
- Figure 4 schematically shows a first variant of the DDS module of Figure 3
- Figure 5 schematically shows a second variant of the DDS module of Figure 3; and
- Figure 6 shows a flow chart of a method of operating a DDS module according to the present invention.

The detailed description set forth below in connection with the appended drawings, where like numerals reference like elements, is intended as a description of various embodiments of the disclosed subject matter and is not intended to represent the only embodiments. Each embodiment described in this disclosure is provided merely as an example or illustration and should not be construed as preferred or advantageous over other embodiments. The illustrative examples provided herein are not intended to be exhaustive or to limit the claimed subject matter to the precise forms disclosed.

For the purposes of the present disclosure, the phrase "at least one of A, B, and C", for example, means (A), (B), (C), (A and B), (A and C), (B and C), or (A, B, and C), including all further possible permutations when more than three elements are listed. In other words, the term "at least one of A and B" generally means "A and/or B", namely "A" alone, "B" alone or "A and B".

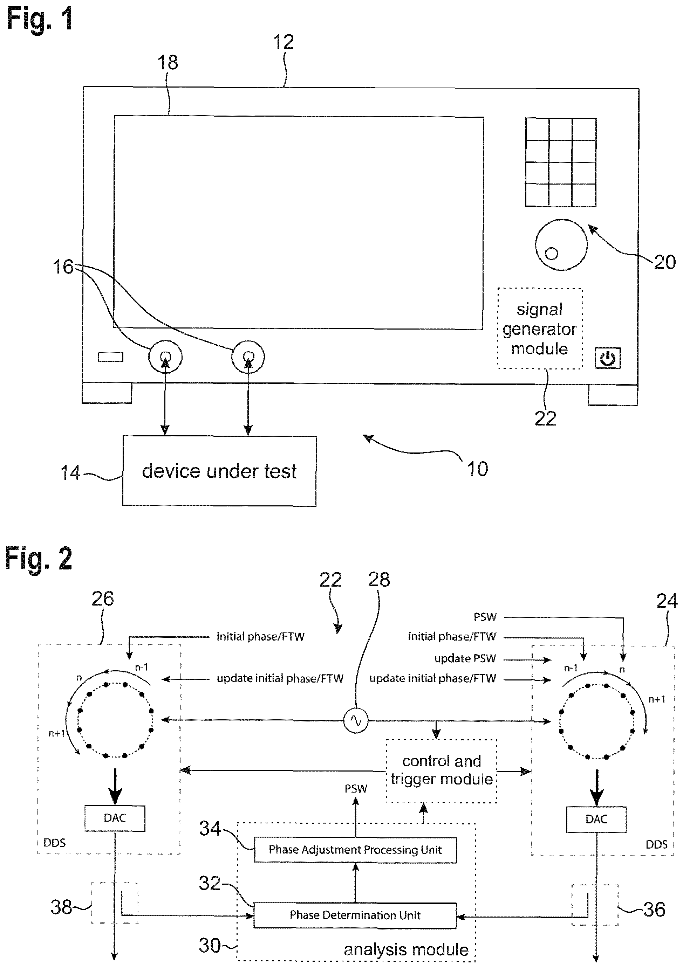

Figure 1 schematically shows a measurement system 10 comprising a measurement instrument 12 and a device under test 14.

In general, the measurement instrument 12 may be established as any type of measurement instrument being suitable to perform measurements on the electronic device under test 14.

For example, the measurement instrument 12 may be established as an oscilloscope, particularly as a digital oscilloscope, as a vector network analyzer, as a spectrum analyzer, as a signal generator, etc.

The measurement instrument 12 comprises two measurement ports 16, wherein measurements can be conducted on the device under test 14 via the measurement ports 16.

In general, signals can be received from the device under test 14 and/or forwarded to the device under test 14 via the measurement ports 16 in order to perform the measurements on the device under test 14.

It is to be understood that the measurement instrument 12 may comprise an arbitrary number of measurement ports 16 other than two.

The measurement instrument 12 may further comprise a display 18 and/or control means 20, wherein settings of the measurement instrument 12 may be adaptable by a user via the control means 20.

The measurement instrument 12 further comprises a signal generator module 22 that is shown in more detail in Figure 2.

In the exemplary embodiment shown in Figure 2, the signal generator module 22 comprises a first direct digital synthesizer (DDS) module 24 and a second DDS module 26.

The first DDS module 24 and the second DDS module 26 are configured to generate an analog output signal, respectively.

Accordingly, the signal generator module 22 is configured to generate two analog outputs signals that may be employed in order to conduct measurements on the device under test 14.

However, it is to be understood that the measurement system 10, particularly the signal generator module 22, may comprise an arbitrary number of DDS modules.

For example, the analog output signals may be used as reference signals for conducting the measurements.

As another example, the analog output signals may be forwarded to different ports of the device under test 14, particularly wherein the analog output signals may correspond to a differential signal. The analog output signals may be processed by the device under test 14 and/or partially reflected at input ports of the device under test 14, and the corresponding processed and/or reflected signals may be measured by means of the measurement instrument 12.

In the exemplary embodiment shown in Figure 2, the signal generator module 22 further comprises a clock source 28 that is configured to provide a clock signal to the first DDS module 24 and to the second DDS module 26.

However, it is also conceivable that the signal generator module 22 comprises a dedicated clock source for each DDS module 24, 26.

The signal generator module 22 further comprises an analysis module 30 that comprises a phase determination unit 32 and a phase adjustment processing unit 34, the functionality of which will be described in more detail below.

The signal generator module 22 further comprises a first directional coupler 36 that is configured to forward the analog output signal of the first DDS module 24 to the analysis module 30. The first directional coupler 36 is further configured to forward the analog output signal of the first DDS module 24 to one of the measurement ports 16 or to another electronic component of the measurement instrument 12.

In fact, the first directional coupler 36 is established as a 3-port coupler.

The signal generator module 22 further comprises a second directional coupler 38 that is configured to forward the analog output signal of the second DDS module 26 to the analysis module 30. The second directional coupler 38 is further configured to forward the analog output signal of the second DDS module 26 to one of the measurement ports 16 or to another electronic component of the measurement instrument 12.

The second directional coupler 38 is established as a 3-port coupler.

The signal generator module 22 further comprises a control- and trigger module 39, the functionality of which will be described in more detail below.

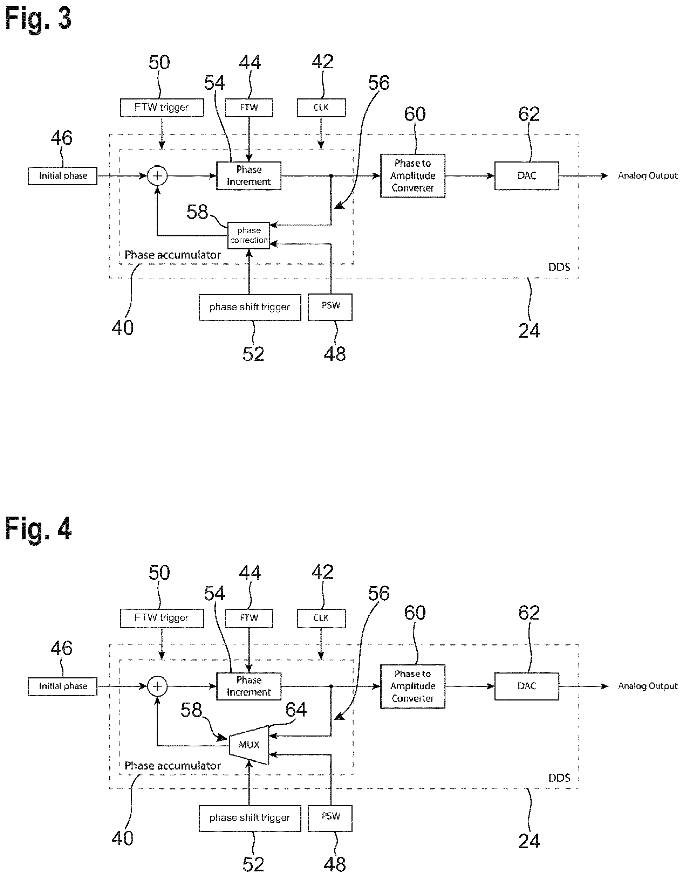

Figure 3 schematically shows a first variant of the first DDS module 24.

For example, the first DDS module 24 may be integrated on a dedicated DDS chip. Alternatively, the first DDS module 24 may be integrated on a chip together with other electronic components of the measurement instrument 12.

The DDS module 24 comprises a phase accumulator module 40.

The phase accumulator module 40 comprises a clock input 42 that is configured to receive a clock signal having a predefined frequency, namely the clock signal generated by the clock source 28.

The phase accumulator module 40 further comprises a frequency tuning register 44 that is configured to receive and save a frequency tuning word (FTW), particularly from the control- and trigger module 39.

In general, the FTW determines a frequency of an output signal of the DDS module 24 in relation to the frequency of the clock signal, as is well-known in the state of the art related to direct digital synthesizers.

The phase accumulator module 40 further comprises an initial phase register 46 being configured to receive and save an initial phase for the phase accumulator module 40.

It is noted that the frequency tuning register 44 and the initial phase register 46 may also be integrated into a single register.

The phase accumulator module 40 further comprises a phase shift register 48 being configured to receive and save a phase shift word (PSW), particularly from the control- and trigger module 39 and/or from the analysis module 30.

Moreover, the phase accumulator module 40 comprises an FTW trigger input 50 and a phase shift trigger input 52.

The FTW trigger input 50 is configured to receive an FTW trigger signal, particularly from the control- and trigger module 39.

The phase shift trigger input 52 is configured to receive a phase shift trigger signal, particularly from the control- and trigger module 39.

The phase accumulator module 40 further comprises a phase increment sub-module 54 and a feedback path 56.

The phase increment sub-module 54 is configured to increment a phase signal output by the phase accumulator module 40 by a predetermined phase increment based on the clock signal and/or based on the FTW.

The feedback path 56 is configured to feed back the phase signal to the phase increment sub-module 54.

The phase accumulator module 40 further comprises a phase correction sub-module 58. In general, the phase correction sub-module 58 is configured to adapt the phase signal fed back to the phase increment sub-module 54 based on the PSW, as will be described in more detail below.

In the embodiment shown in Figure 3, the first DDS module 24 further comprises a converter module 60 and a digital-to-analog converter (DAC) 62.

The converter module 60 is provided downstream of the phase accumulator module 40, and is configured to convert the phase signal output by the phase accumulator module 40 into an amplitude signal.

In general, the converter module 60 is configured to map the phase of the phase signal to a corresponding amplitude of the amplitude signal, such that signals having arbitrary shape can be generated, e.g. sine-shaped amplitude signals, sawtooth-shaped amplitude signals, etc.

The DAC 62 is provided downstream of the converter module 60. The DAC 62 is configured to convert a digital output signal of the first DDS module 24, namely the amplitude signal output by the converter module 60, into an analog output signal of the first DDS module 24.

The second DDS module 26 may be established identically to the first DDS module 24 described above and hereinafter.

However, in principle the second DDS module 26 may be established without the phase shift register 48, the phase shift trigger input 52, and the phase correction sub-module 58.

Figure 4 shows a first variant of the first DDS module 24 described above or rather of the phase correction sub-module 58 of the first DDS module 24 described above.

The phase correction sub-module 58 comprises a multiplexer sub-module 64 that is connected with the phase increment sub-module 54 via the feedback path 56.

Moreover, the multiplexer sub-module 64 is connected with the phase shift register 48 and with the phase shift trigger input 52.

The multiplexer sub-module 64 is configured to selectively forward the phase signal output by the phase increment sub-module 54 or a corrected phase signal to the phase increment sub-module 54.

Thus, in this case, the PSW saved in the phase shift register 48 corresponds to the corrected phase signal, i.e. a desired phase signal that should be output by the phase accumulator module 40 in the current clock cycle.

During normal operation, the multiplexer sub-module 64 is controlled by the control- and trigger module 39 to feed back the phase signal output by the phase increment sub-module 54 to the phase increment sub-module 54.

In order to adapt the phase of the (analog) output signal of the first DDS module 24, the multiplexer sub-module 64 is controlled by the control- and trigger module 39 to forward the corrected phase signal saved in the phase shift register 48 to the phase increment sub-module 54 for exactly one clock cycle of the clock signal.

In other words, the phase signal output by the phase increment sub-module 54 is replaced by the corrected phase signal for one clock cycle.

In fact, the control- and trigger module 39 generates a phase shift trigger signal that is forwarded to the multiplexer sub-module 64 via the phase shift trigger input 52. Upon receiving the phase shift trigger signal, the multiplexer sub-module 64 forwards the corrected phase signal saved in the phase shift register 48 to the phase increment sub-module 54 for exactly one clock cycle.

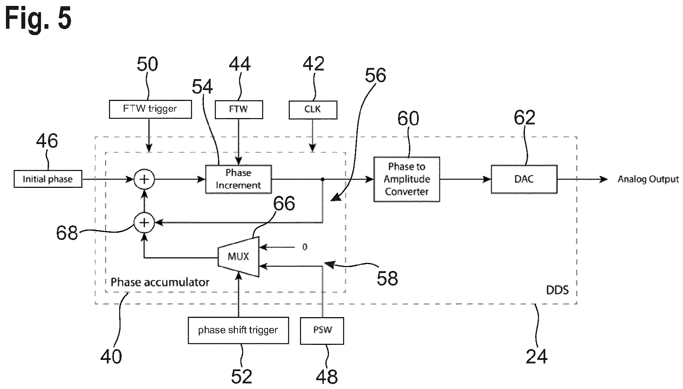

Figure 5 shows a second variant of the first DDS module 24 described above or rather a second variant of the phase correction sub-module 58 of the first DDS module 24 described above.

The phase correction sub-module 58 comprises a multiplexer sub-module 66 that is connected with the phase shift register 48 and with the phase shift trigger input 52.

The phase correction sub-module 58 further comprises an adder sub-module 68 that is provided downstream of the multiplexer sub-module 66.

The multiplexer sub-module 58 is configured to selectively forward a phase correction signal stored in the phase shift register 48 or a zero-signal to the adder sub-module 66, wherein the zero-signal does not alter the phase signal when added to the phase signal.

Thus, in this case, the PSW saved in the phase shift register 48 corresponds to the phase correction signal, i.e. a difference between the desired phase signal and the actual phase signal output by the phase accumulator module 40 in the current clock cycle.

During normal operation, the multiplexer sub-module 66 is controlled by the control- and trigger module 39 to forward the zero-signal to the adder sub-module 68 or to forward no signal at all.

In order to adapt the phase of the (analog) output signal of the first DDS module 24, the multiplexer sub-module 66 is controlled to forward the phase correction signal to the adder sub-module 68 for exactly one clock cycle.

The phase correction signal is added to the phase signal fed back to the phase increment sub-module 54 by means of the adder sub-module 68, such that the phase signal fed back to the phase increment sub-module 54 is adapted for one clock cycle.

Therein, it is to be understood that the phase correction signal may have positive or negative sign, i.e. the adder sub-module 68 may in fact add or subtract a certain phase value to or from the phase signal fed back to the phase increment sub-module 54.

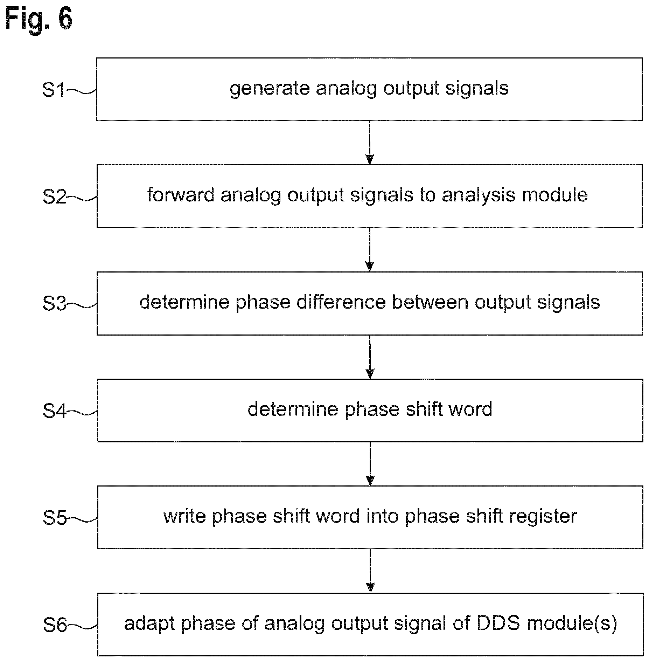

The measurement system 10 described above is configured to perform a method of operating the first DDS module 24. The method is described in the following with reference to Figure 6.

An analog output signal is generated by means of the first DDS module 24 and by means of the second DDS module 26, respectively (step S1).

The control- and trigger module 39 may initialize the DDS modules 24, 26 by providing initial phase values to the initial phase registers 46 of the DDS modules 24, 26, and by providing FTWs to the frequency tuning registers 44 of the DDS modules 24, 26.

The initial phase values are written into the initial phase registers 46, and the FTWs are written into the frequency tuning registers 44 of the DDS modules 24, 26.

The control- and trigger module 39 may then control the DDS modules 24, 26 to start generating the analog outputs signals by generating an FTW trigger signal and by providing the FTW trigger signal to the FTW trigger inputs 50 of the DDS modules 24, 26. Upon receiving the FTW trigger signal, the DDS modules 24, 26 start generating the analog output signals.

The analog output signals are forwarded to the analysis module 30 by means of the first directional coupler 36 and by means of the second directional coupler 38 (step S2).

A phase difference between the output signals of the DDS modules 24, 26 is determined by means of the phase determination unit 32 (step S3).

Therein, the phase determination unit 32 may determine the phase difference between the output signals with respect to certain measurement planes of the measurement system 10 based on calibration data, wherein the calibration data takes phase differences between the phase determination unit 32 and the measurement planes into account.

Accordingly, the determined phase difference may correspond to the phase difference between the output signal of the first DDS module 24 at a first measurement plane and the output signal of the second DDS module at a second measurement plane.

For example, the measurement planes may be adaptable by a user, e.g. via the control means 20 of the measurement instrument 12.

The determined phase difference is forwarded to the phase adjustment processing unit 34.

A PSW is determined for the first DDS module 24 by means of the phase adjustment processing unit 34 based on the determined phase difference (step S4).

Alternatively or additionally to steps S3 and S4 described above, the control- and trigger module 39 may comprise a memory with a data set, wherein the data set comprises FTWs being compatible with the first DDS module 24 and corresponding PSWs.

Accordingly, the PSW may be determined based on the data set, namely based on the FTW of the first DDS module 24, particularly based on the FTW provided to the frequency tuning registers 44 of the first DDS module 24 by means of the control- and trigger module 39.

The PSW is forwarded to the phase shift register 48 of the first DDS module 24, and the PSW is written into the phase shift register 48 (step S5).

The PSW may be forwarded to the phase shift register 48 of the first DDS module 24 directly or via the control- and trigger module 39.

The phase of the output signal of the first DDS module 24 (at the respective measurement plane) is adapted by means of the phase correction sub-module 58 of the first DDS module 24 (step S6).

Accordingly, a desired phase relation between the output signals of the DDS modules 24, 26 is obtained by adapting the phase of the output signal of the first DDS module 24.

More precisely, as described above, the control- and trigger module 39 generates a phase shift trigger signal that causes the phase correction sub-module 58 to adapt the phase of the phase signal fed back to the phase-increment sub-module 54 during a single clock cycle. Thereby, the phase of the output signal of the first DDS module 24 is adapted, particularly in the next clock cycle.

Steps S3 to S6 may be repeated in predefined time intervals. Thus, the phase relation between the analog output signals of the DDS modules 24, 26 may be monitored continuously, and the phase of the analog output signal of the first DDS module 24 may be corrected by providing an appropriate PSW to the first DDS module 24 if necessary.

Alternatively or additionally, steps S1 to S6 described above may be performed after the FTW of at least one of the DDS modules 24, 26 has been updated. Thus, it is ensured that a desired phase relation between the analog output signals of the DDS modules 24, 26 is obtained after the FTW has been updated.

Certain embodiments disclosed herein, particularly the respective module(s) and/or unit(s), utilize circuitry (e.g., one or more circuits) in order to implement standards, protocols, methodologies or technologies disclosed herein, operably couple two or more components, generate information, process information, analyze information, generate signals, encode/decode signals, convert signals, transmit and/or receive signals, control other devices, etc. Circuitry of any type can be used.

In an embodiment, circuitry includes, among other things, one or more computing devices such as a processor (e.g., a microprocessor), a central processing unit (CPU), a digital signal processor (DSP), an application-specific integrated circuit (ASIC), a field-programmable gate array (FPGA), a system on a chip (SoC), or the like, or any combinations thereof, and can include discrete digital or analog circuit elements or electronics, or combinations thereof. In an embodiment, circuitry includes hardware circuit implementations (e.g., implementations in analog circuitry, implementations in digital circuitry, and the like, and combinations thereof).

In an embodiment, circuitry includes combinations of circuits and computer program products having software or firmware instructions stored on one or more computer readable memories that work together to cause a device to perform one or more protocols, methodologies or technologies described herein. In an embodiment, circuitry includes circuits, such as, for example, microprocessors or portions of microprocessor, that require software, firmware, and the like for operation. In an embodiment, circuitry includes one or more processors or portions thereof and accompanying software, firmware, hardware, and the like.

The present application may reference quantities and numbers. Unless specifically stated, such quantities and numbers are not to be considered restrictive, but exemplary of the possible quantities or numbers associated with the present application. Also in this regard, the present application may use the term "plurality" to reference a quantity or number. In this regard, the term "plurality" is meant to be any number that is more than one, for example, two, three, four, five, etc. The terms "about", "approximately", "near" etc., mean plus or minus 5% of the stated value.

## Claims

1. A measurement system comprising at least one direct digital synthesizer, DDS, module, the DDS module (24) comprising a phase accumulator module (40),
wherein the phase accumulator module (40) comprises a clock input (42) being configured to receive a clock signal,
wherein the phase accumulator module (40) further comprises a frequency tuning register (44) being configured to receive a frequency tuning word, FTW,
wherein the phase accumulator module (40) further comprises a phase shift register (48) being configured to receive a phase shift word, PSW,
wherein the phase accumulator module (40) further comprises a phase increment sub-module (54) being configured to increment a phase signal output by the phase accumulator module (40) by a predetermined phase increment based on the clock signal and/or based on the FTW,
wherein the phase accumulator module (40) further comprises a feedback path (56) being configured to feed back the phase signal to the phase increment sub-module (54),
wherein the phase accumulator module (40) further comprises a phase correction sub-module (58), wherein the phase correction sub-module (58) is configured to adapt the phase signal fed back to the phase increment sub-module (54) based on the phase shift word,
wherein the measurement system (10) further comprises an analysis module (30), wherein the analysis module (30) is configured to receive an analog output signal of the at least one DDS module (24), wherein the analysis module (30) is further configured to receive a phase reference signal,
wherein the analysis module (30) is configured to determine a phase difference between the analog output signal of the at least one DDS module (24) and the phase reference signal, and wherein the analysis module (30) further is configured to determine the PSW based on the determined phase difference, and
wherein the measurement system (10) comprises at least one further DDS module (26), wherein the phase reference signal is an analog output signal of the at least one further DDS module (26).

2. The measurement system of claim 1, wherein the phase correction sub-module (58) is configured to receive a phase shift trigger signal, and wherein the phase correction sub-module (58) is configured to adapt the phase signal fed back to the phase increment sub-module (54) upon receiving the phase shift trigger signal.

3. The measurement system according to any one of the preceding claims, wherein the phase correction sub-module (58) is configured to replace the phase signal fed back to the phase increment sub-module (54) with a corrected phase signal, particularly wherein the phase correction sub-module (58) comprises a multiplexer sub-module (64), wherein the multiplexer sub-module (64) is configured to selectively forward the phase signal or the corrected phase signal to the phase increment sub-module.

4. The measurement system of claim 3, wherein the phase correction sub-module (58) is configured to replace the phase signal fed back to the phase increment sub-module (54) with a corrected phase signal during a single clock cycle of the clock signal.

5. The measurement system according to any one of the preceding claims, wherein the phase correction sub-module (58) is configured to add a phase correction signal to the phase signal fed back to the phase increment sub-module (54), particularly wherein the phase correction sub-module (58) comprises an adder sub-module (68), wherein the adder sub-module (68) is configured to add the phase correction signal to the phase signal fed back to the phase increment sub-module (54).

6. The measurement system of claim 5, wherein the phase correction sub-module (58) comprises a multiplexer sub-module (66), wherein the multiplexer sub-module (68) is configured to selectively forward the phase correction signal to the adder sub-module (68).

7. The measurement system of claim 5 or 6, wherein the phase correction sub-module (58) is configured to add the phase correction signal to the phase signal fed back to the phase increment sub-module (54) during a single clock cycle of the clock signal.

8. The measurement system according to any one of the preceding claims, comprising a measurement instrument (12), wherein the at least one DDS module (24) is integrated into the measurement instrument (12).

9. The measurement system according to any one of the preceding claims, wherein the analysis module (30) is configured to repeatedly determine the PSW in predefined time intervals.

10. The measurement system according to any one of the preceding claims, wherein the measurement system (10) comprises a directional coupler (36), and wherein the directional coupler (36) is configured to forward the analog output signal of the at least one DDS module (24) to the analysis module (30).

11. The measurement system according to any one of the preceding claims, wherein the measurement system (10) comprises a common clock source (28) for the at least one DDS module (24) and for the at least one further DDS module (26).

12. A method of operating at least one direct digital synthesizer, DDS, module (24) by means of a measurement system (10), wherein the measurement system (10) is established according to any one of claims 1 to 11, the method comprising the steps of:
- generating, by means of the at least one DDS module (24), an analog output signal:
- receiving, by means of the analysis module (30), the analog output signal and a phase reference signal, wherein the phase reference signal is an analog output signal of the at least one further DDS module (26);
- determining, by means of the analysis module (30), a phase shift word, PSW, based on the analog output signal and based on the phase reference signal, wherein a phase difference between the analog output signal of the at least one DDS module (24) and the phase reference signal is determined, and wherein the PSW is determined based on the determined phase difference; and
- adapting, by means of the phase correction sub-module (58) of the at least one DDS module (24), the phase signal output by the phase accumulator module (40) based on the PSW.

## Patentansprüche

1. Messsystem, umfassend mindestens ein Modul eines direkten digitalen Synthesizers, DDS-Modul, das DDS-Modul (24) umfassend ein Phasenakkumulatormodul (40),
wobei das Phasenakkumulatormodul (40) einen Takteingang (42) umfasst, der konfiguriert ist, um ein Taktsignal zu empfangen,
wobei das Phasenakkumulatormodul (40) ferner ein Frequenzabstimmregister (44) umfasst, das konfiguriert ist, um ein Frequenzabstimmwort, FTW, zu empfangen,
wobei das Phasenakkumulatormodul (40) ferner ein Phasenverschiebungsregister (48) umfasst, das konfiguriert ist, um ein Phasenverschiebungswort, PSW, zu empfangen,
wobei das Phasenakkumulatormodul (40) ferner ein Phaseninkrementteilmodul (54) umfasst, das konfiguriert ist, um ein Phasensignal, das durch das Phasenakkumulatormodul (40) ausgegeben wird, um ein vorbestimmtes Phaseninkrement basierend auf dem Taktsignal und/oder basierend auf dem FTW zu inkrementieren,
wobei das Phasenakkumulatormodul (40) ferner einen Rückkopplungspfad (56) umfasst, der konfiguriert ist, um das Phasensignal an das Phaseninkrementteilmodul (54) rückzukoppeln,
wobei das Phasenakkumulatormodul (40) ferner ein Phasenkorrekturteilmodul (58) umfasst, wobei das Phasenkorrekturteilmodul (58) konfiguriert ist, um das Phasensignal, das an das Phaseninkrementteilmodul (54) rückgekoppelt wird, basierend auf dem Phasenverschiebungswort anzupassen,
wobei das Messsystem (10) ferner ein Analysemodul (30) umfasst, wobei das Analysemodul (30) konfiguriert ist, um ein analoges Ausgangssignal des mindestens einen DDS-Moduls (24) zu empfangen, wobei das Analysemodul (30) ferner konfiguriert ist, um ein Phasenreferenzsignal zu empfangen,
wobei das Analysemodul (30) konfiguriert ist, um eine Phasendifferenz zwischen dem analogen Ausgangssignal des mindestens einen DDS-Moduls (24) und dem Phasenreferenzsignal zu bestimmen, und wobei das Analysemodul (30) ferner konfiguriert ist, um das PSW basierend auf der bestimmten Phasendifferenz zu bestimmen, und
wobei das Messsystem (10) mindestens ein weiteres DDS-Modul (26) umfasst, wobei das Phasenreferenzsignal ein analoges Ausgangssignal des mindestens einen weiteren DDS-Moduls (26) ist.

2. Messsystem nach Anspruch 1, wobei das Phasenkorrekturteilmodul (58) konfiguriert ist, um ein Phasenverschiebungstriggersignal zu empfangen, und wobei das Phasenkorrekturteilmodul (58) konfiguriert ist, um das Phasensignal, das an das Phaseninkrementteilmodul (54) rückgekoppelt wird, bei dem Empfangen des Phasenverschiebungstriggersignals anzupassen.

3. Messsystem nach einem der vorstehenden Ansprüche, wobei das Phasenkorrekturteilmodul (58) konfiguriert ist, um das Phasensignal, das an das Phaseninkrementteilmodul (54) rückgekoppelt wird, durch ein korrigiertes Phasensignal zu ersetzen, insbesondere wobei das Phasenkorrekturteilmodul (58) ein Multiplexer-Teilmodul (64) umfasst, wobei das Multiplexer-Teilmodul (64) konfiguriert ist, um selektiv das Phasensignal oder das korrigierte Phasensignal an das Phaseninkrementteilmodul weiterzuleiten.

4. Messsystem nach Anspruch 3, wobei das Phasenkorrekturteilmodul (58) konfiguriert ist, um das Phasensignal, das an das Phaseninkrementteilmodul (54) rückgekoppelt wird, während eines einzelnen Taktzyklus des Taktsignals durch ein korrigiertes Phasensignal zu ersetzen.

5. Messsystem nach einem der vorstehenden Ansprüche, wobei das Phasenkorrekturteilmodul (58) konfiguriert ist, um ein Phasenkorrektursignal zu dem Phasensignal zu addieren, das an das Phaseninkrementteilmodul (54) rückgekoppelt wird, insbesondere wobei das Phasenkorrekturteilmodul (58) ein Addiererteilmodul (68) umfasst, wobei das Addiererteilmodul (68) konfiguriert ist, um das Phasenkorrektursignal zu dem Phasensignal zu addieren, das an das Phaseninkrementteilmodul (54) rückgekoppelt wird.

6. Messsystem nach Anspruch 5, wobei das Phasenkorrekturteilmodul (58) ein Multiplexer-Teilmodul (66) umfasst, wobei das Multiplexer-Teilmodul (68) konfiguriert ist, um das Phasenkorrektursignal selektiv an das Addiererteilmodul (68) weiterzuleiten.

7. Messsystem nach Anspruch 5 oder 6, wobei das Phasenkorrekturteilmodul (58) konfiguriert ist, um das Phasenkorrektursignal während eines einzelnen Taktzyklus des Taktsignals zu dem Phasensignal zu addieren, das an das Phaseninkrementteilmodul (54) rückgekoppelt wird.

8. Messsystem nach einem der vorstehenden Ansprüche, umfassend ein Messinstrument (12), wobei das mindestens eine DDS-Modul (24) in das Messinstrument (12) integriert ist.

9. Messsystem nach einem der vorstehenden Ansprüche, wobei das Analysemodul (30) konfiguriert ist, um die PSW in vordefinierten Zeitintervallen wiederholt zu bestimmen.

10. Messsystem nach einem der vorstehenden Ansprüche, wobei das Messsystem (10) einen Richtkoppler (36) umfasst, und wobei der Richtkoppler (36) konfiguriert ist, um das analoge Ausgangssignal des mindestens einen DDS-Moduls (24) an das Analysemodul (30) weiterzuleiten.

11. Messsystem nach einem der vorstehenden Ansprüche, wobei das Messsystem (10) eine gemeinsame Taktquelle (28) für das mindestens eine DDS-Modul (24) und für das mindestens eine weitere DDS-Modul (26) umfasst.

12. Verfahren zum Betreiben mindestens eines Moduls des direkten digitalen Synthesizers, DDS-Moduls, (24) mittels eines Messsystems (10), wobei das Messsystem (10) nach einem der Ansprüche 1 bis 11 eingerichtet ist, das Verfahren umfassend die Schritte:
- Erzeugen, mittels des mindestens einen DDS-Moduls (24), eines analogen Ausgangssignals;
- Empfangen, mittels des Analysemoduls (30), des analogen Ausgangssignals und eines Phasenreferenzsignals, wobei das Phasenreferenzsignal ein analoges Ausgangssignal des mindestens einen weiteren DDS-Moduls (26) ist;
- Bestimmen, mittels des Analysemoduls (30), eines Phasenverschiebungsworts, PSW, basierend auf dem analogen Ausgangssignal und basierend auf dem Phasenreferenzsignal, wobei eine Phasendifferenz zwischen dem analogen Ausgangssignal des mindestens einen DDS-Moduls (24) und dem Phasenreferenzsignal bestimmt wird, und wobei das PSW basierend auf der bestimmten Phasendifferenz bestimmt wird; und
- Anpassen, mittels des Phasenkorrekturteilmoduls (58) des mindestens einen DDS-Moduls (24), des Phasensignals, das durch das Phasenakkumulatormodul (40) ausgegeben wird, basierend auf dem PSW.

## Revendications

1. Système de mesure comprenant au moins un module de synthétiseur numérique direct, DDS, le module DDS (24) comprenant un module accumulateur de phase (40),
dans lequel le module accumulateur de phase (40) comprend une entrée d'horloge (42) étant configurée pour recevoir un signal d'horloge,
dans lequel le module accumulateur de phase (40) comprend en outre un registre d'accord de fréquence (44) étant configuré pour recevoir un mot d'accord de fréquence, FTW,
dans lequel le module accumulateur de phase (40) comprend en outre un registre de décalage de phase (48) étant configuré pour recevoir un mot de décalage de phase, PSW,
dans lequel le module accumulateur de phase (40) comprend en outre un sous-module d'incrément de phase (54) étant configuré pour incrémenter un signal de phase délivré en sortie par le module accumulateur de phase (40) d'un incrément de phase prédéterminé en fonction du signal d'horloge et/ou en fonction du FTW,
dans lequel le module accumulateur de phase (40) comprend en outre un chemin de réinjection (56) étant configuré pour réinjecter le signal de phase au sous-module d'incrément de phase (54),
dans lequel le module accumulateur de phase (40) comprend en outre un sous-module de correction de phase (58), dans lequel le sous-module de correction de phase (58) est configuré pour adapter le signal de phase réinjecté au sous-module d'incrément de phase (54) en fonction du mot de décalage de phase,
dans lequel le système de mesure (10) comprend en outre un module d'analyse (30), dans lequel le module d'analyse (30) est configuré pour recevoir un signal de sortie analogique de l'au moins un module DDS (24), dans lequel le module d'analyse (30) est en outre configuré pour recevoir un signal de référence de phase,
dans lequel le module d'analyse (30) est configuré pour déterminer une différence de phase entre le signal de sortie analogique de l'au moins un module DDS (24) et le signal de référence de phase, et dans lequel le module d'analyse (30) est en outre configuré pour déterminer le PSW en fonction de la différence de phase déterminée, et
dans lequel le système de mesure (10) comprend au moins un autre module DDS (26), dans lequel le signal de référence de phase est un signal de sortie analogique de l'au moins un autre module DDS (26).

2. Système de mesure selon la revendication 1, dans lequel le sous-module de correction de phase (58) est configuré pour recevoir un signal de déclenchement de décalage de phase, et dans lequel le sous-module de correction de phase (58) est configuré pour adapter le signal de phase réinjecté dans le sous-module d'incrément de phase (54) lors de la réception du signal de déclenchement de décalage de phase.

3. Système de mesure selon l'une quelconque des revendications précédentes, dans lequel le sous-module de correction de phase (58) est configuré pour remplacer le signal de phase réinjecté dans le sous-module d'incrément de phase (54) par un signal de phase corrigé, en particulier dans lequel le sous-module de correction de phase (58) comprend un sous-module multiplexeur (64), dans lequel le sous-module multiplexeur (64) est configuré pour transmettre sélectivement le signal de phase ou le signal de phase corrigé au sous-module d'incrément de phase.

4. Système de mesure selon la revendication 3, dans lequel le sous-module de correction de phase (58) est configuré pour remplacer le signal de phase réinjecté au sous-module d'incrément de phase (54) par un signal de phase corrigé pendant un seul cycle d'horloge du signal d'horloge.

5. Système de mesure selon l'une quelconque des revendications précédentes, dans lequel le sous-module de correction de phase (58) est configuré pour additionner un signal de correction de phase au signal de phase réinjecté dans le sous-module d'incrément de phase (54), en particulier dans lequel le sous-module de correction de phase (58) comprend un sous-module additionneur (68), dans lequel le sous-module additionneur (68) est configuré pour additionner le signal de correction de phase au signal de phase réinjecté dans le sous-module d'incrément de phase (54).

6. Système de mesure selon la revendication 5, dans lequel le sous-module de correction de phase (58) comprend un sous-module multiplexeur (66), dans lequel le sous-module multiplexeur (68) est configuré pour transmettre sélectivement le signal de correction de phase au sous-module additionneur (68).

7. Système de mesure selon la revendication 5 ou 6, dans lequel le sous-module de correction de phase (58) est configuré pour additionner le signal de correction de phase au signal de phase réinjecté dans le sous-module d'incrément de phase (54) pendant un cycle d'horloge unique du signal d'horloge.

8. Système de mesure selon l'une quelconque des revendications précédentes, comprenant un instrument de mesure (12), dans lequel l'au moins un module DDS (24) est intégré dans l'instrument de mesure (12).

9. Système de mesure selon l'une quelconque des revendications précédentes, dans lequel le module d'analyse (30) est configuré pour déterminer de manière répétée le PSW dans des intervalles de temps prédéfinis.

10. Système de mesure selon l'une quelconque des revendications précédentes, dans lequel le système de mesure (10) comprend un coupleur directionnel (36), et dans lequel le coupleur directionnel (36) est configuré pour transmettre le signal de sortie analogique de l'au moins un module DDS (24) au module d'analyse (30).

11. Système de mesure selon l'une quelconque des revendications précédentes, dans lequel le système de mesure (10) comprend une source d'horloge commune (28) pour l'au moins un module DDS (24) et pour l'au moins un autre module DDS (26).

12. Procédé de fonctionnement d'au moins un module de synthétiseur numérique direct, DDS, (24) au moyen d'un système de mesure (10), dans lequel le système de mesure (10) est établi selon l'une quelconque des revendications 1 à 11, le procédé comprenant les étapes consistant à :
- générer, au moyen de l'au moins un module DDS (24), un signal de sortie analogique ;
- recevoir, au moyen du module d'analyse (30), le signal de sortie analogique et un signal de référence de phase, dans lequel le signal de référence de phase est un signal de sortie analogique de l'au moins un autre module DDS (26) ;
- déterminer, au moyen du module d'analyse (30), un mot de décalage de phase, PSW, en fonction du signal de sortie analogique et en fonction du signal de référence de phase, dans lequel une différence de phase entre le signal de sortie analogique de l'au moins un module DDS (24) et le signal de référence de phase est déterminée, et dans lequel le PSW est déterminé en fonction de la différence de phase déterminée ; et
- adapter, au moyen du sous-module de correction de phase (58) de l'au moins un module DDS (24), le signal de phase délivré en sortie par le module accumulateur de phase (40) en fonction du PSW.
